# NEUE EUROPÄISCHE PATENTSCHRIFT

(11) **EP 2 625 747 B2**
(45) Veröffentlichungstag und Bekanntmachung des Hinweises auf die Entscheidung über den Einspruch: **19.12.2018**
(45) Hinweis auf die Patenterteilung: 06.01.2016
(21) Anmeldenummer: 11758177.7
(22) Anmeldetag: 12.09.2011
(51) Int. Cl.: H01R 9/24, H01R 9/26, H01R 13/627, H01R 13/635, H01R 13/66, G01R 1/04

(54) **ZUSATZANSCHLUSSSTECKER**
ADDITIONAL ATTACHMENT PLUG
FICHE DE CONNEXION SUPPLÉMENTAIRE

(30) Priorität: 07.10.2010 DE 202010014008 U
(43) Veröffentlichungstag der Anmeldung: 14.08.2013
(73) Patentinhaber: Weidmüller Interface GmbH & Co. KG, 32758 Detmold (DE)
(72) Erfinder: MÜNSTERMANN, Jörg, 33189 Schlangen (DE); DIEKMANN, Torsten, 33618 Leopoldshöhe (DE); SCHMIDTPOTT, Heike, 32105 Bad Salzuflen (DE); ADAMCZYK, Martin, 32758 Detmold (DE)
(74) Vertreter: Specht, Peter
(86) Internationale Anmeldenummer: PCT/EP2011/065765
(87) Internationale Veröffentlichungsnummer: WO 2012/045551

(56) Entgegenhaltungen:
- EP-A2- 1 189 307
- EP-A2- 1 921 715
- DE-A1-102004 040 859
- DE-C1- 19 709 054

## Beschreibung

Die Erfindung betrifft einen Zusatzanschlussstecker nach dem Oberbegriff des Anspruchs 1.

Ein solcher Zusatzanschlussstecker dient zum Einstecken in Geräte wie insbesondere anreihbare Anschlussklemmen, um für anzuschließende Geräte eine zusätzliche Funktion, wie beispielsweise eine Absicherung und/oder Anzeige, bereitzustellen.

Die gattungsgemäße DE 197 09 054 C1 beschreibt einen Prüfstecker für das Einstecken in Zugangsöffnungen von Zugfederanschlüssen eines Reihenklemmengehäuses. Der Prüfstecker weist ein Steckergehäuse mit einer einseitig festgelegten Stromschiene und einem in dem Steckergehäuse verschiebbar geführten Betätigungswerkzeug auf, das zur Betätigung von Zugfederanschlüssen ausgebildet ist. Beim Einstecken des Prüfsteckers muss zunächst mit dem Betätigungswerkzeug der Zugfederanschluss geöffnet werden, damit die Stromschiene des Prüfsteckers eingeführt werden kann. Zum Lösen des Prüfsteckers wird das Betätigungswerkzeug erneut betätigt. Der Einsatz eines solchen Prüfsteckers für das Einstecken in Direktsteckanschlüsse, die Klemmfedern mit Selbsthemmung aufweisen, ist jedoch nicht möglich.

Die Aufgabe der vorliegenden Erfindung besteht daher darin, einen verbesserten Zusatzanschlussstecker zu schaffen, der leicht wieder dem Direktsteckanschluss der Anschlussklemme entnehmbar ist.

Die Aufgabe wird durch einen Zusatzanschlussstecker mit den Merkmalen des Anspruchs 1 gelöst.

Die Erfindung betrifft die Auslegung der Oberfläche bzw. der Oberflächenbeschaffenheit eines Klemmabschnitts, also eines Bereichs, in welchem die Klemmfeder des Direktsteckanschlusses an der steckerstiftartigen "Stromschieneneinrichtung" des Zusatzanschlusssteckers im eingesteckten Zustand anliegt, als nicht selbsthemmend. Dies kann dadurch erreicht werden, dass der Klemmabschnitt aus einem harten Metall - Stahl - vorzugsweise einem Edelstahl besteht, welches eine relativ geringe Rauigkeit aufweist, bzw. welches ferner eines solche glatte Oberfläche aufweist, dass der Zusatzstecker vorzugsweise mit Handkraft aus der Anschlussstelle an der Klemmfeder gezogen werden kann. Durch die relativ große Härte des Materials des Klemmabschnitts wird erreicht, dass sich die Klemmfeder nicht oder nur vernachlässigbar in das Material des Klemmabschnitts eingraben kann. Der Stahl bietet die gewünschten Eigenschaften. Zudem ist er nicht zu teuer.

Nach der Erfindung weist das Stromschienenelement also zumindest in dem Bereich, in welchem an ihm im in ein Gerät eingesteckten Zustand die Klemmfeder anliegt, eine solche Oberflächenbeschaffenheit auf, dass die Stromschieneneinrichtung nicht selbsthemmend von der Klemmfeder festgelegt wird, so dass es gegen die Federkraft ohne Zusatzmaßnahmen wieder aus der Klemmstelle ausziehbar ist.

Dies wird dadurch erreicht, dass die Stromschieneneinrichtung abschnittsweise mit dem harten Metall beschichtet ist. Dieses harte Metall ist ein Stahlmaterial, insbesondere ein Edelstahlmaterial.

Die Stromschieneneinrichtung ist aus mindestens zwei Schichten aufgebaut. Dabei kann es einen leitenden Kern aufweisen, der mit einem elektrisch nicht leitenden ummantelt ist, wobei außen an diesem Mantel wieder abschnittsweise das harte Material Stahl aufgebracht sein kann.

Nach einer Weiterbildung ermöglicht der Zusatzanschlussstecker ein werkzeugloses Einstecken in Direktsteckanschlüsse und ein einfaches Lösen der Klemmwirkung des Direktsteckanschlusses durch ein im Zusatzanschlussstecker verschiebbar geführtes Schiebeelement mit einem Druckabschnitt, welcher mit einer Betätigungseinrichtung des Direktsteckanschlusses zusammenwirkt.

Das Stromschienenelement ist mehrteilig aufgebaut. Dadurch ergibt sich der Vorteil, dass das Stromschienenelement geometrisch optimal an den Direktsteckanschluss der Anschlussklemme angepasst ist, um ein leichtes Einstecken und gleichzeitig einen festen und im Wesentlichen wackelfreien Sitz zu gewährleisten.

Ein Vorteil besteht darin, dass weder zum Einstecken noch zum Herausziehen des Zusatzanschlusssteckers Werkzeuge notwendig sind.

Das Schiebeelement kann im Gehäuse des Zusatzanschlusssteckers unverlierbar angeordnet und über einen Griff manuell betätigbar sein, sodass einerseits weder Zusatzteile noch Werkzeuge notwendig sind, um den Zusatzanschlussstecker einzustecken und zu lösen.

In einer Ausführung ist ein Teil der Stromschieneneinrichtung zur Gewährleistung einer Fingersicherheit aus einem Kunststoff gebildet. Dabei kann der elektrisch leitende Steckerkontaktabschnitt aus einem metallischen Werkstoff bestehen, wobei vorteilhaft ein nur geringer Metalleinsatz mit Kostenersparnis möglich ist. Zum einen kann dadurch Gewicht eingespart und zum anderen gleichzeitig die oben erwähnte Stabilität in einer eingesteckten Position erreicht werden.

Die Stromschieneneinrichtung weist dann vorzugsweise nur außen in einem geringen Bereich seiner Oberfläche den Klemmabschnitt auf, der vorzugsweise aus dem genannten harten, im eingesteckten Zustand nicht selbst hemmend im Direktsteckanschluss festgeklemmten Material besteht.

Dadurch wird die Selbsthemmungsfunktion der Klemmfeder des Direktsteckanschlusses, in welchen der Zusatzanschlussstecker eingesteckt ist, quasi außer Kraft gesetzt. Die Selbsthemmungsfunktion verhindert an sich ein Herausziehen eines Leiters aus der Anschlussklemme. Dies ist bei dem Zusatzstecker, wenn dieser nicht dauerhaft sondern zum Beispiel zu Prüfzwecken gesetzt wird, nicht erforderlich. Da der Klemmabschnitt aus einem derartigen Material gefertigt ist, können die Herstellkosten trotz des Materialeinsatzes von Stahl relativ gering gehalten werden.

Der Zusatzanschlussstecker kann insbesondere für diesen Fall außerdem mit einem Verriegelungselement zur Verriegelung mit der zuzuordnenden Anschlussklemme versehen sein, wodurch der Hält an der Anschlussklemme gesichert wird, auch wenn die an sich vorhandene Selbsthemmungswirkung des Direktsteckanschlusses, wie sie beispielsweise beim Kontaktieren einer Stromschiene aus einem weicheren Material wie Kupfer vorhanden ist, außer Kraft gesetzt wird.

Das Verriegelungselement kann ferner an dem Gehäuse des Zusatzanschlusssteckers wieder entfernbar anbringbar sein. Somit ist eine große Vielseitigkeit des Zusatzanschlusssteckers für unterschiedliche Zusatzanschlüsse ermöglicht, indem bei großer mechanischer Belastung das Verriegelungselement zusätzlich anklipsbar ist.

Die Betätigungseinrichtung und die Einführungsöffnung für den elektrischen Leiter können auf einer Oberseite des Gehäuses des Zusatzanschlusssteckers angeordnet sein. Dabei ist es vorteilhaft, dass die Betätigungseinrichtung in einer Einführungsrichtung des anzuschließenden Leiters erreichbar ist, was eine Anschlussarbeit verkürzt.

Das Gehäuse des Zusatzanschlusssteckers kann zur Bestückung mit Sicherungselementen und/oder Anzeigeelementen sowie weiteren Bauteilen vorgesehen sein. Somit ist eine Vielzahl von zusätzlichen Funktionen für anzuschließende Geräte möglich.

Eine Anschlussvorrichtung mit mindestens einer Anschlussklemme mit einer Anschlusseinrichtung, welche als Direktanschluss mit einer Klemmfeder und Selbsthemmung ausgebildet ist, weist mindestens den einen oben beschriebenen Zusatzanschlussstecker auf und ist reversibel mit diesem versehbar.

Ein weiterer Vorteil ist gegeben, wenn die Anschlusseinrichtung des Zusatzanschlusssteckers ebenfalls als Direktsteckanschluss wie die Anschlusseinrichtung der Anschlussklemme ausgelegt ist, denn dies sorgt ergänzend für eine relativ geringe Teilezahl.

Anhand beispielhafter Ausführungen wird die Erfindung mit Bezug auf die beigefügten Zeichnungen näher erläutert. Hierbei zeigen:
- Figur 1: eine schematische perspektivische Ansicht eines ersten Ausführungsbeispiels eines erfindungsgemäßen Zusatzanschlusssteckers vor dem Einstecken in eine Anschlussklemme;
- Figur 2-2A: eine Seitenansicht und eine Frontansicht des ersten Ausführungsbeispiels nach Figur 1;
- Figur 3: eine Teilschnittansicht einer Stromschiene des ersten Ausführungsbeispiels nach Figur 1 in eingesteckter Position;
- Figur 4: eine vergrößerte schematische perspektivische Ansicht eine nicht erfindungsgemäße Variante des ersten Ausführungsbeispiels vor dem Einstecken in eine Anschlussklemme;
- Figur 4A-4B: eine perspektivische Teilansicht und eine Teilschnittansicht eines Stromschienenelementes der Variante nach Figur 4 in eingesteckter Position;
- Figur 5: eine schematische perspektivische Darstellung einer Anschlussvorrichtung mit zweiten Ausführungsbeispielen des erfindungsgemäßen Zusatzanschlusssteckers;
- Figur 5A-5B: schematische perspektivische Darstellungen des zweiten Ausführungsbeispiels des erfindungsgemäßen Zusatzanschlusssteckers;
- Figur 6: eine schematische perspektivische Darstellung einer weiteren Anschlussvorrichtung mit einer Variante des zweiten Ausführungsbeispiels des erfindungsgemäßen Zusatzanschlusssteckers;
- Figur 6A-6B: schematische perspektivische Darstellungen der Variante des zweiten Ausführungsbeispiels des erfindungsgemäßen Zusatzanschiusssteckers;
- Figur 7: eine schematische perspektivische Darstellung einer noch weiteren Anschlussvorrichtung mit einer weiteren Variante des zweiten Ausführungsbeispiels des erfindungsgemäßen Zusatzanschlusssteckers;
- Figur 7A-7B: schematische perspektivische Darstellungen der weiteren Variante des zweiten Ausführungsbeispiels des erfindungsgemäßen Zusatzanschlusssteckers;
- Figur 8: eine Teilschnittansicht eines Zusatzanschlusssteckers in eingesteckter Position mit einer Löseeinrichtung;
- Figur 8A-8B: schematische perspektivische Ansichten von Schiebeelementen; und
- Figur 9-11: Seiten- und Schnittansichten weiterer Ausführungsbeispiele des erfindungsgemäßen Zusatzanschlusssteckers;
- Figur 12: eine Seitenansicht eines weiteren Ausführungsbeispiele eines erfindungsgemäßen Zusatzanschlusssteckers an einer Anschlussklemme.

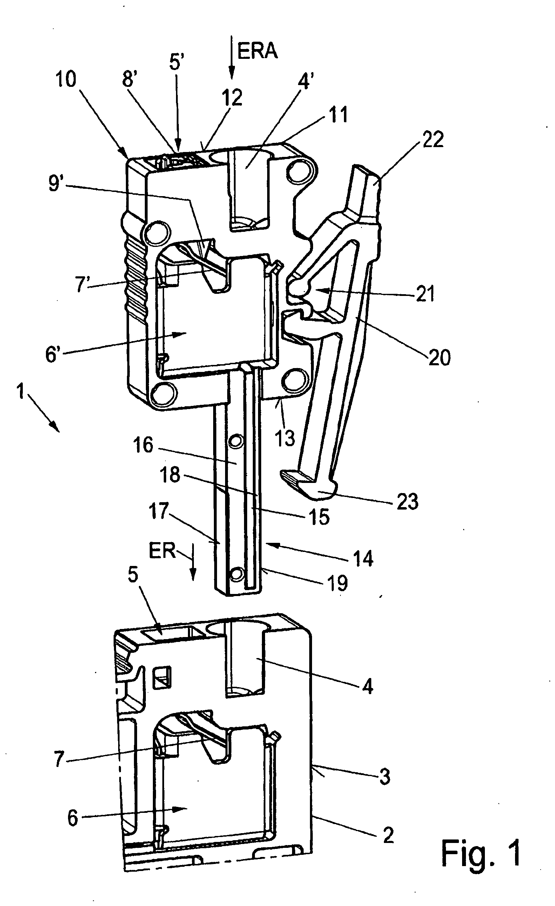

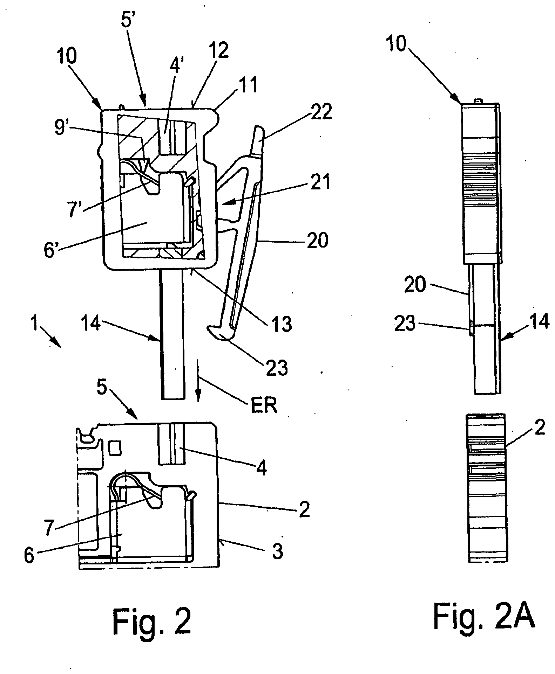

Figur 1 zeigt eine schematische perspektivische Ansicht eines ersten Ausführungsbeispiels eines erfindungsgemäßen Zusatzanschlusssteckers 10 vor dem Einstecken in eine Anschlussklemme 2. Figur 2A stellt eine Seitenansicht und Figur 2B eine Frontansicht des ersten Ausführungsbeispiels nach Figur 1 dar.

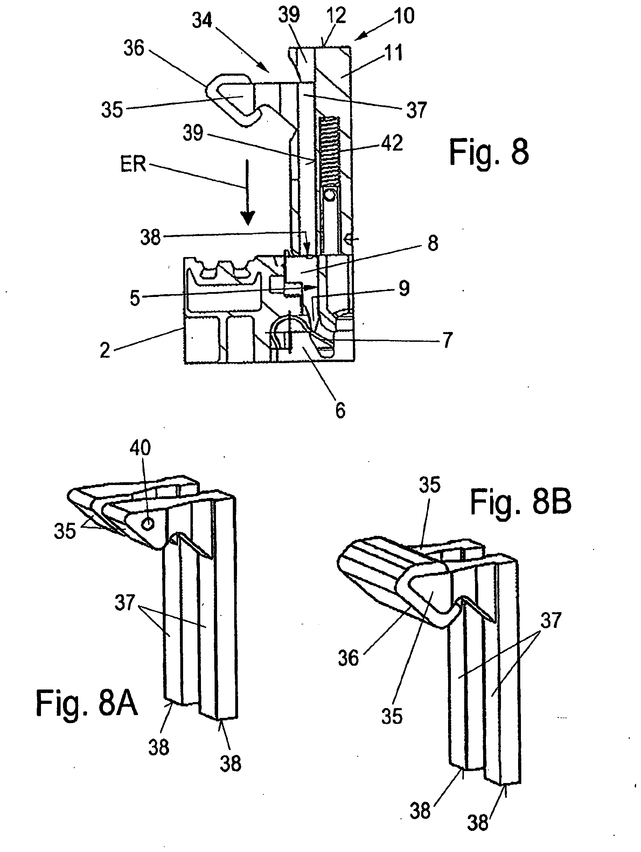

Eine Anschlussvorrichtung 1 umfasst mindestens eine oder mehrere Anschlussklemme(2) und einen Zusatzsteckeranschluss 10. Die Anschlussklemme 2 besitzt in ihrem nicht näher dargestellten Klemmengehäuse eine Anschlusseinrichtung 6, die als ein so genannter Direktsteckanschluss, der auch als Push-In bezeichnet wird, mit einer Klemmfeder 7 mit einer gegenüber einer Stromschiene aus Kupfermaterial "Selbsthemmung" ausgebildet ist und unten noch näher erläutert wird. Zur Einführung eines Leiters in einer Einführungsrichtung ER zum Anschluss an die Anschlusseinrichtung 6 weist die Anschlussklemme 2 in dem Klemmengehäuse über der Anschlusseinrichtung 6 eine Einführungsöffnung 4 auf. Zum Lösen eines eingesteckten Leiters ist die Anschlussklemme 2 mit einer Betätigungseinrichtung 5 versehen, mit welcher die Klemmfeder 7 betätigbar ist, wie unten noch beschrieben wird. Die Betätigungseinrichtung 5 und die Einführungsöffnung 4 sind beide von der gleichen Seite her in Einführungsrichtung ER erreichbar. Ein Betätiger 8 (siehe Figur 8), welcher auch als Pusher bezeichnet wird, der Betätigungseinrichtung 5 ist hier noch nicht eingesetzt, es somit die Führung, welche sich in Einführungsrichtung ER erstreckt, fürdiesen in der Anschlussklemme 2 sichtbar.

Der Zusatzanschlussstecker 10 weist ein Gehäuse 11 mit einer Oberseite 12 und einer Unterseite 13 auf, in welchem ebenfalls wenigstens eine oder mehrere Anschlusseinrichtung(en) 6' eingebracht und als Direktsteckanschluss mit einer Klemmfeder 7' mit Selbsthemmung ausgebildet ist/sind.

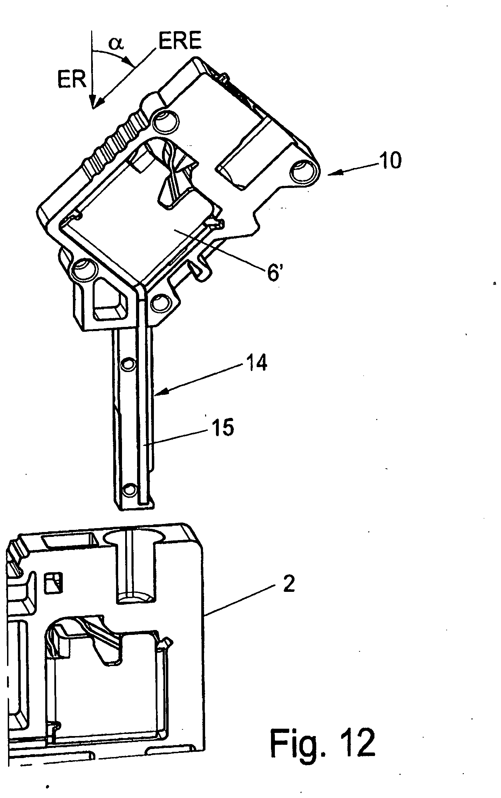

Es ist auch eine andere Ausführung als Anschlusseinrichtung 6' möglich. Die Anschlusseinrichtung weist hier eine Leitereinführrichtung ERA aus, welche parallel zu einer Steckrichtung ausgerichtet ist. Zwischen diesen beiden Richtungen kann jedoch auch ein Winkel bestehen, d.h., die Anschlusseinrichtung 6' wäre in diesem Fall winklig (Winkel α) zur Leitereinführrichtung ER ausgerichtet (Fig. 12).

Weiterhin ist das Gehäuse 11 wie bei der Anschlussklemme 2 mit einer Einführungsöffnung 4' und einer Betätigungseinrichtung 5' auf der Oberseite 12 des Gehäuses 11 versehen.

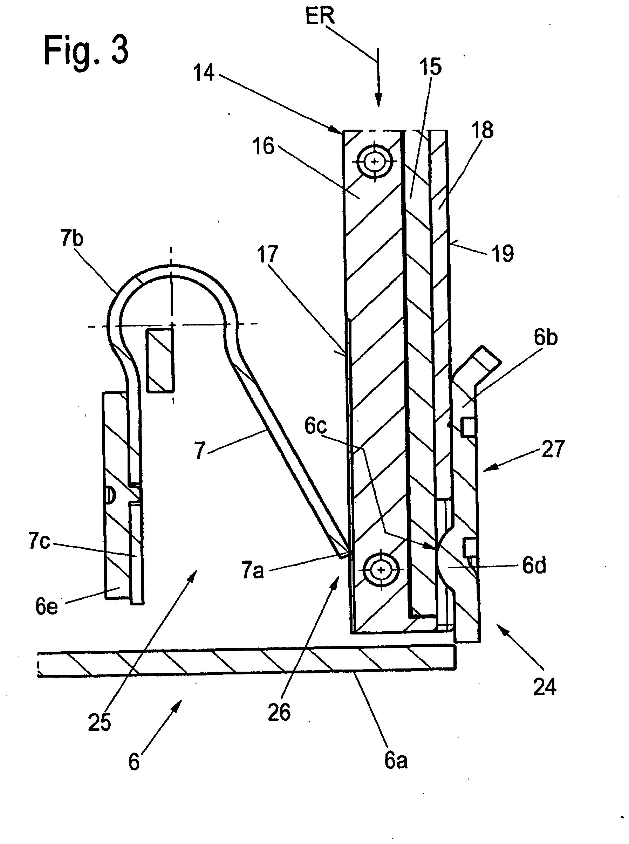

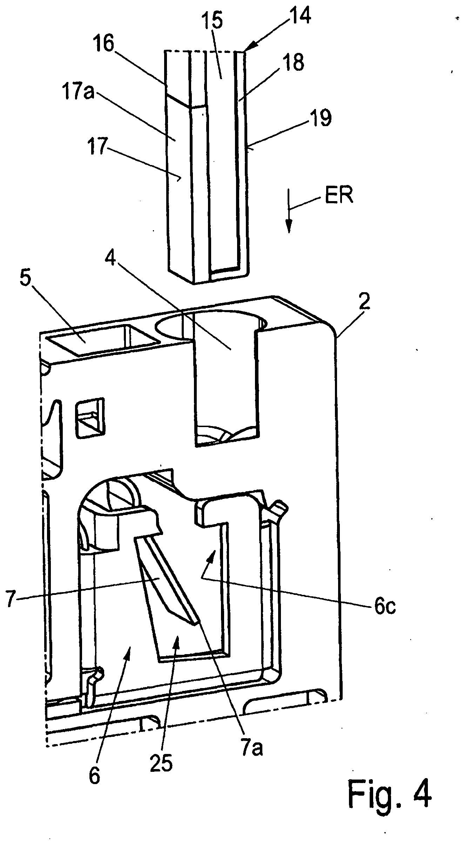

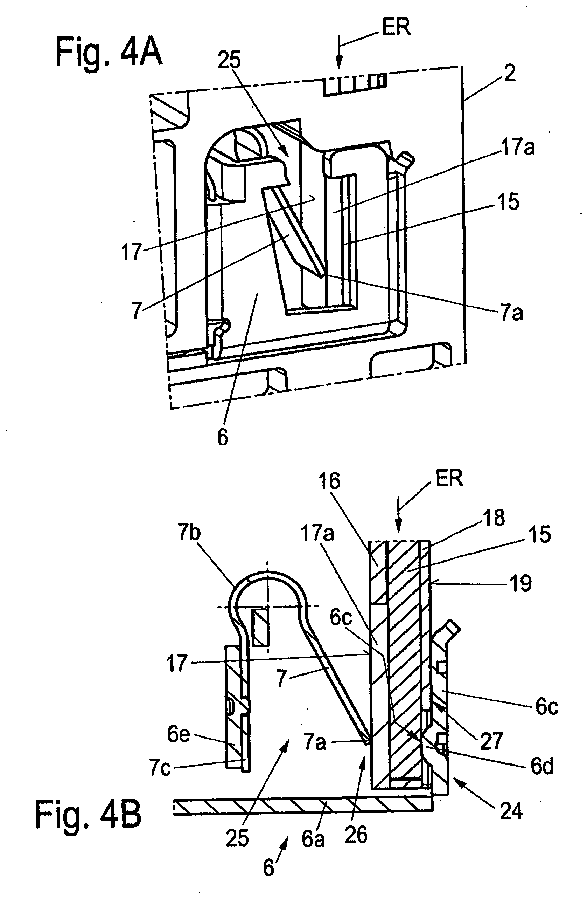

Die Betätigungseinrichtung 5' ist hier mit einem Betätiger 8' gezeigt, der in Einführungsrichtung ER von der Oberseite 12 her betätigbar und verschiebbar im Gehäuse 11 geführt ist. An seiner Unterseite weist der Betätiger 8' einen Betätigungsabschnitt 9' auf, der mit der Klemmfeder 7' zusammenwirkt (siehe auch Figur 2, 10 und 11). Das Gehäuse 11 ist als Quaderform ausgebildet, wobei die schmale Oberseite 12 und die Unterseite 13 über Seiten verbunden sind, von denen die linke in Figur 1 und 2 mit einer Grifffläche versehen ist, und die rechte eine Aufnahme aufweist, die Bestandteil eines Gelenks 21 für ein aufklipsbares oder angeformtes Verriegelungselement 20 ist. Zu dieser rechten Seite hin ist die Einführungsöffnung 4' angeordnet. Der Verriegelungshebel 20 weist ein oberes Ende mit einem Drücker 22 etwa in einer Höhe unterhalb der Oberseite 12 und ein unteres Ende mit einem zur linken Seite des Gehäuses 11 hin weisenden Haken 23, der sich auf einer Höhe unterhalb derUnterseite 13 etwa in der Mitte eines Stromschienenelementes 14 befindet. Der Verriegelungshebel 20 ist um das Gelenk 21 verschwenkbar, wobei er durch eine nicht näher beschriebene Federwirkung in die in Figur 1 und 2 gezeigten Lage vorgespannt ist und durch Druck auf den Drücker 22 gegen den Uhrzeigersinn verschwenkbar ist. Bei in die Anschlussklemme 2 eingestecktem Zusatzanschlussstecker 10 (Figuren 3, 4A und 4B) rastet der Haken 23 in eine nicht gezeigte korrespondierende Ausnehmung an einer Stirnseite 3 der Anschlussklemme 2 in nicht näher dargestellter Weise ein und kann durch Druck auf den Drücker 22 wieder gelöst werden, wie leicht vorstellbar ist.

An der Unterseite 13 des Zusatzanschlusssteckers 10 ist ein sich in Einführungsrichtung ER erstreckendes Stromschieneneinrichtung 14 angeordnet, der zur Zusammenwirkung mit der Anschlusseinrichtung 6 der Anschlussklemme 2 bestimmt ist. Dementsprechend ist eine Länge der Stromschieneneinrichtung 14 von der Unterseite 13 des Zusatzanschlusssteckers 10 her bis zum Ende korrespondierend mit einem Längenmaß von Oberkante der Anschlussklemme 2 durch die Einführungsöffnung 4 bis zu einem Boden der Anschlusseinrichtung 6 (siehe auch Figur 3 und 4B) einschließlich eines Spiels zwischen Ende des Stromschienenelementes 14 und dem Boden der Anschlusseinrichtung 6 ausgelegt.

Die Stromschieneneinrichtung 14 weist in dieser Ausführung einen an die Einführungsöffnung 4 der Anschlussklemme 2 angepassten rechteckigen Querschnitt auf. Die Stromschieneneinrichtung 14 ist mehrteilig aufgebaut. Hier ist eine mehrteilige oder auch mehrschichtige Ausführung gezeigt, welche einen als Stromschienenabschnitt ausgebildeten Kern 15, einen Träger 16 mit einem Klemmabschnitt 17 und einen Rand vorzugsweise aus Kunststoff 18 aufweist. Wenn das Stromschienenelement abschnittsweise insbesondere im Randbereich aus isolierendem Kunststoff besteht, kann auf einfache Weise eine genügende Fingersicherheit realisiert werden.

In der gezeigten Ausführung ist der Träger 16 etwa dreimal so dick wie der Rand 18 und weist zur linken Seite des Gehäuses 11 (in Figur 1 und 2) hin.

Der Träger 16 erstreckt sich aus dem Gehäuse 11 des Zusatzanschlusssteckers 10, in dem er befestigt ist, rechtwinklig zur Unterseite 13 in Einführungsrichtung ER parallel zu dem Rand 18, mit dem er an dem freien Ende des Stromschienenelementes 14 verbunden ist.

Zwischen dem Träger 16 und dem Rand 18 und parallel zu diesen ist der als Stromschienenabschnitt wirkende Kern 15, welcher etwa doppelt so dick wie der Kunststoffrand 18 ist, eingeschlossen.

Der Rand 18 verläuft durch die Unterseite 13 des Gehäuses 11 zur rechten Seite des Gehäuses 11 hin weisend (in Figur 1 und 2) und ist mit der Anschlusseinrichtung 6' des Zusatzanschlusssteckers 10 elektrisch leitend verbunden.

Im Bereich der unteren Hälfte der Stromschieneneinrichtung 14 ist der Klemmabschnitt 17 in nicht erfindungsgemäßer Ausführung aus einem flach gewalzten Stahlblech auf dem Träger 16 angeordnet. Er ist vorzugsweise derartige Oberflächenbeschaffenheit, insbesondere Härte und geringe Rauigkeit, auf, dass keine Selbsthemmung in Zusammenwirkung mit der Klemmfeder 7 (siehe Figur 3) auftritt.

Die Lage des Randes 18 und des Trägers 16 mit dem zum Rand 18 gegenüberliegenden, nicht selbsthemmend wirkenden Klemmabschnitt 17 korrespondiert mit der Anordnung von Klemmfeder 7 und Klemmstück 6b in der Anschlusseinrichtung 6, wie dies aus den Figuren 3 und 4B, die unten noch im Detail beschrieben werden, hervorgeht.

Figur 2 zeigt den Zusatzanschlussstecker 10 mit einem Deckel, der zu besseren Anschauung durchbrochen ist. In Figur 2A ist die linke Seite aus Figur 1 mit der Grifffläche gezeigt. Der Zusatzanschlussstecker 10 wird in Einführungsrichtung ER in die Anschlussklemme 2 eingesteckt und mit dem Verriegelungselement 20 an dieser verriegelt. Das Stromschienenelement bzw. der Kern 15 wird bei dem Einführungsvorgang durch die Einführungsöffnung 4 der Anschlussklemme 2 in die Anschlusseinrichtung 6 eingeführt. Diese eingesteckte Position der Stromschiene 15 des ersten Ausführungsbeispiels nach Figur 1 ist in Figur 3 in einer Teilschnittansicht gezeigt.

Die Anschlusseinrichtung 6 weist einen Käfig 6a auf, in welchem ein Direktsteckanschluss 25 mittels der Klemmfeder 7 gebildet ist. Der Käfig 6a ist mit dem Kontaktstück 6b und einem Federhalter 6e verbunden. Das Kontaktstück 6b ist parallel zur Einführungsrichtung ER und steht senkrecht auf einem Boden des Käfigs 6a. Es ist mit einer Kontaktfläche 6c und einem Vorsprung 6d versehen, welche beide zum Innenraum des Käfigs 6a weisen. Die Klemmfeder 7 verläuft schräg von oben nach unten, weist an ihrem unteren, freien zum Kontaktstück 6b hin weisenden Ende eine Kante 7a auf und ist über einen Bogenabschnitt 7b, der einen Winkel von etwa 220° aufweist, mit einem Halteschenkel 7c verbunden. Sie ist somit auch im Ruhezustand, in dem sie am Kontaktstück 6b anliegt, vorgespannt. Der Halteschenkel 7c ist an dem Federhalter 6e festgelegt. Die Klemmfeder 7 ist durch das eingeführte Stromschienenelement 15 des Zusatzanschlusssteckers 10 im Uhrzeigersinn in den Innenraum des Käfigs 6a verschwenkt und weiter gespannt. Dabei steht die Kante 7a der Klemmfeder 7 in einem Klemmbereich 26 in Kontakt mit der Klemmfläche 17. Die gespannte Klemmfeder 7 drückt auf diese Weise das Stromschienenelement 15 gegen das Kontaktstück 6b, dessen Kontaktfläche 6c einen elektrischen Kontakt mit der Steckerkontaktfläche 19 des Steckerkontaktabschnitts 15 des Zusatzanschlusssteckers 10 in einem Kontaktbereich 27 bildet.

Der Vorsprung 6d ist dabei in einer Ausnehmung des Trägers 16 oder des Randes 18 aufgenommen und kann eine Führung und einen Rastabschnitt 24 für das Stromschienenelement 15 bilden.

Bei einer Klemmstellung der Anschlussvorrichtung 6, 6' ist die Stellung der Klemmfeder 7 dergestalt, in welcher ein eingesteckter Leiter von der Klemmfeder 7 gegen das Kontaktstück 6b gedrückt oder bei nicht vorhandenem Leiter gegen das Kontaktstück 6b gedrückt wird. In einer gelösten Stellung ist die Klemmfeder 7 durch die Betätigungseinrichtung 5, 5' von dem Kontaktstück 6b in den Innenraum des Käfigs 6a so verschwenkt, dass ein vorher geklemmter Leiter gelöst ist und herausgezogen oder zwischen Klemmfeder 7 und Kontaktstück 6b eingesteckt werden kann.

Der über dem Klemmbereich 26 angeordnete Bogenabschnitt 7b der Klemmfeder 7 würde an sich mit der Klemmfeder 7 und deren Kante 7a eine Selbsthemmung der Anschlusseinrichtung 6 gegen Herausziehen des eingesteckten Stromschienenelementes 15 in entgegengesetzter Einführungsrichtung ER bieten. Dies wird aber durch den Klemmabschnitt aus Stahl aufgehoben bzw. vermieden. Auf diese Weise kann der Zusatzanschlussstecker 10 in die Anschlussklemme 2 ohne Werkzeug eingesetzt und in fester Position gehalten werden.

Diese Beschreibung der Anschlusseinrichtung 6 gilt ebenso für die Anschlusseinrichtung 6' des Zusatzanschlusssteckers 10, wenn dieser mit einem solchen Direktsteckanschluss ausgerüstet ist.

Figur 4 zeigt eine vergrößerte schematische perspektivische Ansicht einer nicht erfindungsgemäßen Variante des ersten Ausführungsbeispiels vor dem Einstecken in die Anschlussklemme 2, und Figuren 4A und 4B stellen jeweils eine perspektivische Teilansicht und eine Teilschnittansicht des Stromschienenelementes 15 der Variante nach Figur 4 in eingesteckter Position dar.

Die Beschreibung der Figuren 4, 4A und 4B entspricht im Wesentlichen derjenigen der Figuren 1, 2, 2A und 3. Daher werden nur die Unterschiede zu diesen Figuren angegeben. Der Aufbau dieser Variante des Stromschienenelementes 15 ist dergestalt, dass der als das Stromschienenelement dienende Kern 15 etwa zweimal so dick wie der Träger 16. Das untere Ende des Trägers 16 ist ausgespart und durch einen separaten Klemmabschnitt 17a mit der Klemmfläche 17 ersetzt. Dabei ist der Klemmabschnitt 17 wiederum z.B. aus einem harten Metall gebildet, um für die Klemmfläche 17 eine Selbsthemmung zu verhindern.

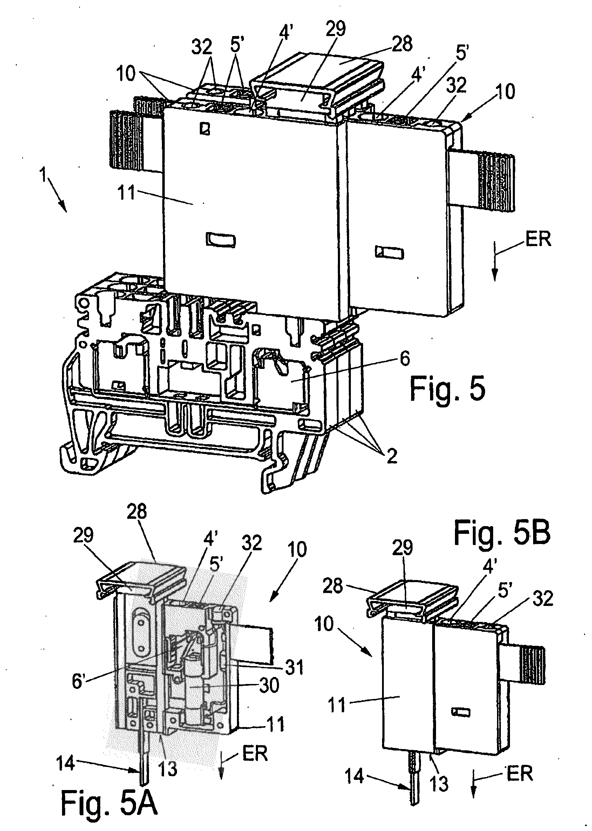

Figur 5 ist eine schematische perspektivische Darstellung einer Anschlussvorrichtung 1 mit zweiten Ausführungsbeispielen des erfindungsgemäßen Zusatzanschlusssteckers 10. Die Figuren 5A und 5B zeigen schematische perspektivische Darstellungen des zweiten Ausführungsbeispiels des erfindungsgemäßen Zusatzanschlusssteckers 10.

In Figur 5 sind beispielhaft drei Anschlussklemmen 2 als Reihenklemmen mit jeweiligen Anschlusseinrichtungen 6 als Direktsteckanschlüsse gezeigt. Hier sind drei Zusatzanschlussstecker 10 in einer zweiten Ausführung in die Anschlussklemmen 2 eingesteckt und ruhen mit ihren Unterseiten 13 auf den jeweiligen Oberseiten der Anschlussklemmen. Ein Zusatzanschlussstecker 10 ist zwischen zwei weiteren um eine Achse in Einführungsrichtung ER um 180° verdreht angeordnet. Dies ist möglich, wenn das jeweilige Stromschienenelement 15 beidseitig elektrisch leitend ausgebildet ist. Zum Beispiel kann dazu das Stromschienenelement 15 nach Figur 1 zur Anwendung kommen, wobei der Träger 16 aus dem gleichen elektrisch leitenden Material wie der als Steckerkontaktabschnitt dienende Stromschienenelement 15.

Die Zusatzanschlussstecker 10 dieses zweiten Ausführungsbeispiels weisen an ihren Oberseiten 12 jeweils ein Profil 29 auf, über welche sie mittels einer so genannten Schildschiene 28 mechanisch untereinander verbunden werden können. Dadurch können mehrere der Stecker 10 gleichzeitig bedient werden. Anstelle der Schildschiene 28 kann auch z.B. ein Verbindungsstift oder dergleichen mit entsprechenden Durchgangslöchern (nicht dargestellt) Anwendung finden, was leicht vorstellbar ist.

Mittels der Zusatzanschlussstecker 10 können anzuschließende elektrische Komponenten in Reihe mit zusätzlichen Funktionselementen, wie beispielsweise Sicherungen und Funktionsanzeigen, in einfacher Weise ausgestattet werden. So hat eine Sicherung die Aufgabe, den Anschluss an den Zusatzanschlussstecker 10 zu sichern. Dazu zeigt Figur 5A einen geöffneten Zusatzanschlussstecker 10 mit einem im Gehäuse 11 angeordneten Sicherungselement 30, welches die Stromschieneneinrichtung 14 mit der Anschlusseinrichtung 6' verbindet. Das Sicherungselement 30 ist hier ein Standardbauelement, das in einer Halterung auswechselbar gehalten ist und senkrecht, d.h. parallel zur Einführungsrichtung ER angeordnet ist. Sie kann in einer nicht gezeigten Variante auch schräg angeordnet sein. Außerdem ist das Sicherungselement 30 mit einem Anzeigeelement 32 gekoppelt, welches bei defektem Sicherungselement 30 dies durch Nichtleuchten oder Leuchten anzeigt. Das Anzeigeelement 32 ist hier eine Leuchtdiode, die über einen Widerstand 31 angeschlossen ist, der auch in dem Gehäuse 11 des Zusatzanschlusssteckers 10 des zweiten Ausführungsbeispiels angeordnet ist. Werden mehrere Zusatzanschlussstecker 10 hintereinander in Reihe gesteckt, so kann das Anzeigeelement 32 bei Ausfall eines Sicherungselementes 30 zur Identifikation des entsprechenden Zusatzanschlusssteckers 10 dienen.

Figur 5B zeigt den durch einen Deckel verschlossenen Zusatzanschlussstecker 10. Hierbei kann das Stromschienenelement 15 vollständig aus elektrisch leitendem Material bestehen, wobei ein oberer Abschnitt des Stromschienenelementes 15 mit eine Ummantelung umgeben ist, die zur Führung des Stromschienenelementes 15 in der Einführungsöffnung 4 der zugehörigen Anschlussklemme 2 dient.

Der Zusatzanschlussstecker 10 kann ferner eine Löseeinrichtung 34, die weiter unten noch näher erläutert wird, aufweisen, um ihn aus eingesteckter Position in der Anschlussklemme 2 zu lösen. Diese Löseeinrichtung 34 betätigt dann die Betätigungseinrichtung 5 der Anschlussklemme 2.

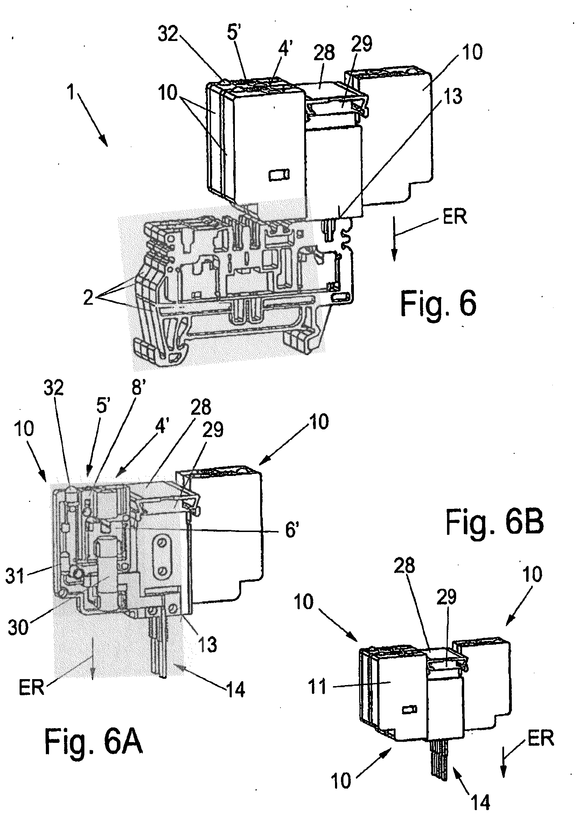

Ähnlich zu den Figuren 5, 5A und 5B zeigen die Figuren 6, 6A und 6B eine schematische perspektivische Darstellung einer weiteren Anschlussvorrichtung mit einer Variante des zweiten Ausführungsbeispiels des erfindungsgemäßen Zusatzanschlusssteckers 10 und schematische perspektivische Darstellungen dieses Zusatzanschlusssteckers 10.

In dieser Variante ist das Gehäuse 11 des Zusatzanschlusssteckers 10 im Bereich der Anschlusseinrichtung 6 höher als ein Mittelabschnitt, welcher das Profil 29 trägt. Innerhalb dieses Mittelabschnitts kann, ebenso wie in der Variante der Figuren 5, 5A und 5B eine Löseeinrichtung 34 angeordnet sein.

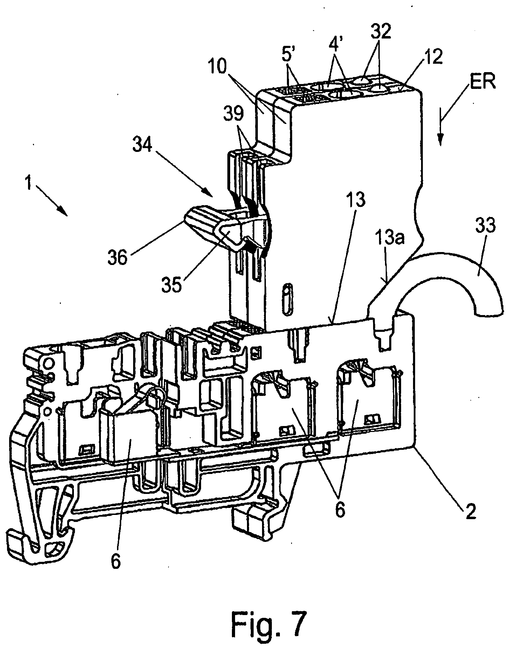

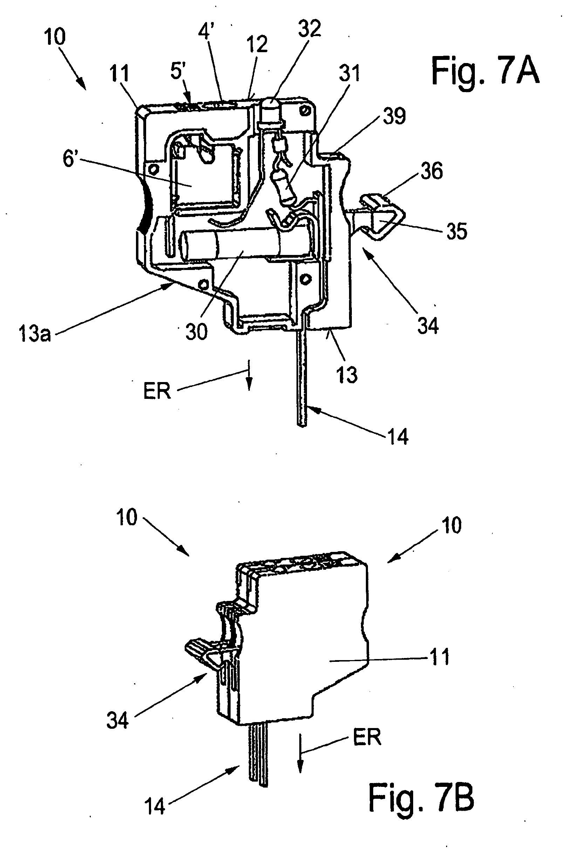

Figur 7 zeigt eine schematische perspektivische Darstellung einer noch weiteren Anschlussvorrichtung 1 mit einer weiteren Variante des zweiten Ausführungsbeispiels des erfindungsgemäßen Zusatzanschlusssteckers 10, wobei Figuren 7A und 7B schematische perspektivische Darstellungen der weiteren Variante illustrieren.

Im Unterschied zu den Figuren 5, 5A, 5B, 6, 6A und 6B weist die Anschlussvorrichtung 1 in Figur 7 auf einer Seite zwei Anschlusseinrichtungen 6 auf, von denen in der linken der Zusatzanschlussstecker 10 und in der daneben liegenden rechten ein Leiter 33 eingesteckt und angeschlossen sind. Es sind hier zwei nebeneinander angeordnete Zusatzanschlussstecker 10 in eingesteckter Position gezeigt.

Diese Variante des zweiten Ausführungsbeispiels weist eine Unterseite 13 auf, welche auf einer Seite (in Figur 7 die rechte Seite) im letzten Drittel in einer Schräge 13a schräg nach oben (in einem Winkel von etwa 40...45°verläuft, wodurch bei dieser Anschlussklemme 2 mit zwei Anschlusseinrichtungen 6 nebeneinander der Anschluss des Leiters 33 ermöglicht wird.

An der Seite des Zusatzanschlusssteckers 10, welche der Schräge 13a gegenüberliegt, ist die Löseeinrichtung 34 mit einem Griff 35 in einem Führungskanal 39 angeordnet und in Einführungsrichtung ER verschiebbar. Die Löseeinrichtung 34 wird unten im Zusammenhang mit den Figuren 8, 8A und 8B eingehend beschrieben. Durch ein Verbindungselement 36, welches über die nebeneinander liegenden Griffe 35 mehrerer Zusatzanschlussstecker 10 (hier sind nur zwei gezeigt) schiebbar ist und diese miteinander verbindet, ist es möglich alle so verbundenen Löseeinrichtungen 34 gleichzeitig zu betätigen.

Figur 7A zeigt das zweite Ausführungsbeispiels des Zusatzanschlusssteckers 10 in ohne Deckel. Das Sicherungselement 30 ist hier waagerecht, d.h. rechtwinklig zur Einführungsrichtung ER angeordnet. Die Stromschieneneinrichtung 14 ist in diesem Beispiel massiv ausgebildet. Die Löseeinrichtung 34 ist neben dem Stromschienenelement 15 angeordnet. In Figur 7B sind zwei Zusatzanschlussstecker 10 des zweiten Ausführungsbeispiels nebeneinander angeordnet und geschlossen gezeigt.

Figur 8 stellt eine Teilschnittansicht eines Zusatzanschlusssteckers 10 in eingesteckter Position mit einer Löseeinrichtung 34 dar.

Der Zusatzanschlussstecker 10 liegt mit seiner Unterseite 13 auf der Oberseite der zugehörigen Anschlussklemme 2 auf, in welche er eingesteckt ist und welche nur in einem Teilschnitt gezeigt ist.

Die Löseeinrichtung 34 weist ein Schiebeelement 37 auf, welches mit einem Körper, der z.B. einen rechteckigen Querschnitt besitzt, in einem Führungskanal 39 im Gehäuse 11 des Zusatzanschlusssteckers 10 verschiebbar geführt und unverlierbar gehalten ist. Der Führungskanal 39 verläuft in Einführungsrichtung ER. Das Schiebeelement 37 ist an seinem oberen Ende mit dem sich waagerecht, d.h. rechtwinklig zur Einführungsrichtung ER, erstreckenden Griff 35 versehen, auf den hier das Verbindungselement 36 aufgeschoben ist. Ein unteres Ende des Schiebeelementes 37 bildet einen Druckabschnitt 38, welcher mit dem Betätiger 8 der Betätigungseinrichtung 5 der Anschlussklemme 2 zusammenwirkt. Der Druckabschnitt 38 kontaktiert eine Oberseite des Betätigers 8. In unbetätigter Stellung des Schiebeelementes 37 kann der Druckabschnitt 38 den Betätiger 8 berühren oder von ihm abstehen, verstellt ihn aber nicht. Dabei kann der Druckabschnitt von der Unterseite 13 des Gehäuses 11 auch nach innen abstehen oder mit ihr fluchten. Bei betätigter Stellung wirkt der Druckabschnitt 38 mit der Betätigungseinrichtung 5 der Klemmfeder 7 des Direktanschlusses 25 der Anschlussklemme 2 zusammen, indem zum Lösen der Zusatzanschlusssteckers 10 aus der eingesteckten Position aus der Anschlussklemme 2 das Schiebeelement 37 durch Druck auf den Griff 35 in Einführungsrichtung ER betätigt wird. Über den Druckabschnitt 38 wird dadurch der Betätiger 8 ebenfalls in Einführungsrichtung ER verschoben und verschwenkt durch Druck seines Betätigungsabschnitts 9 die Klemmfeder 7 aus der Klemmstellung, welche z.B. in Figur 3 und 4B gezeigt ist. Damit ist die Klemmung und Selbsthemmung aufgehoben, die Stromschieneneinrichtung 14 ist gelöst und der Zusatzanschlussstecker 10 kann aus der Anschlussklemme 2 in entgegengesetzter Einführungsrichtung ER herausgezogen werden. Eine nicht dargestellte Druckfeder kann dabei unterstützend wirken, indem sie den Zusatzanschlussstecker 10 in entgegengesetzter Einführungsrichtung ER anhebt, was leicht vorstellbar ist. Diese Druckfeder kann im Zusatzanschlussstecker 10 angeordnet sein.

In Figur 8A und 8B sind schematische perspektivische Ansichten von Schiebeelementen 37 dargestellt.

Figur 8A zeigt zwei Schiebeelemente 37, die über einen Verbindungsstift 40, der in Durchgangslöchern der Griffe 35 eingesteckt ist, verbunden sind. Der Querschnitt des Schiebeelementes 37 ist rechteckig, kann aber auch z.B. dreieckig oder vieleckig oder anders ausgebildet sein, so dass eine Verdrehsicherung im Führungskanal 39 gewährleistet ist.

In Figur 8B sind die beiden Schiebeelemente 37 vergrößert mit dem Verbindungselement 36 gezeigt. Das Verbindungselement 36 hat ein Innenprofil, welches dem Außenprofil der Griffe 35 entspricht.

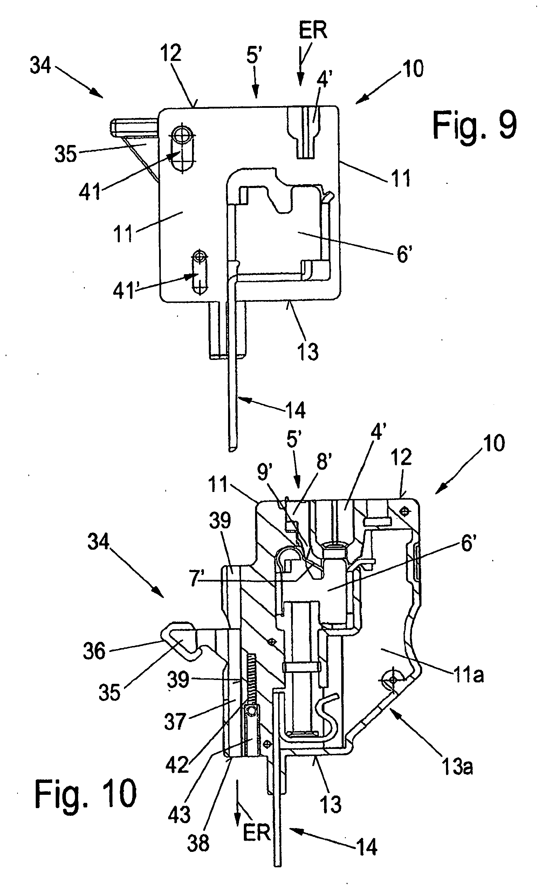

Die Figuren 9 bis 11 zeigen Seiten- und Schnittansichten weiterer Ausführungsbeispiele des erfindungsgemäßen Zusatzanschlusssteckers 10.

In Figur 9 ist ein Zusatzanschlussstecker 10 in einer Seitenansicht dargestellt, der hier beispielhaft nur eine Anschlusseinrichtung 6' aufweist. Mehrere der Zusatzanschlussstecker sind auch realisierbar.

Das Schiebeelement 37 kann mittels Langlochführungen 41, 41' im Hub begrenzt und gleichzeitig unverlierbar im Gehäuse 11 geführt gehalten sein. Eine Feder 42, die hier auf einen verschieblichen Stift 43 einwirkt, sichert ergänzend ein leichtes Abheben des Zusatzanschlussteckers 10, wenn er gelöst wird.

Figur 10 zeigt einen Zusatzanschlussstecker 10 mit einer Anschlusseinrichtung 6' und einem unbestückten Einbauraum 11 a im Gehäuse 11. Dieser Zusatzanschlussstecker 10 ist für eine kundenspezifische Bestückung vorgesehen, die z.B. ein Kunde selbst vornehmen kann. Hierbei ist schon eine Sicherungshalterung vorgesehen und die Unterseite 13 des Gehäuses 11 mit der Schräge 13a versehen. Auch ein Einbauraum für ein Anzeigeelement ist vorgesehen. Die Anschlusseinrichtung 6' ist wie die in Figur 8 dargestellte Anschlusseinrichtung 6 mit einer Betätigungseinrichtung 5' mit einem Betätiger 8' über dessen Betätigungsabschnitt 9', der mit der Klemmfeder 7' zusammenwirkt, betätigbar. Einführungsöffnung 4' und Betätigungseinrichtung 5' sind von der Oberseite 12 her erreichbar. Das Stromschienenelement 15 ist massiv und in seinem oberen Abschnitt in einem Vorsprung des Gehäuses 11 gehalten.

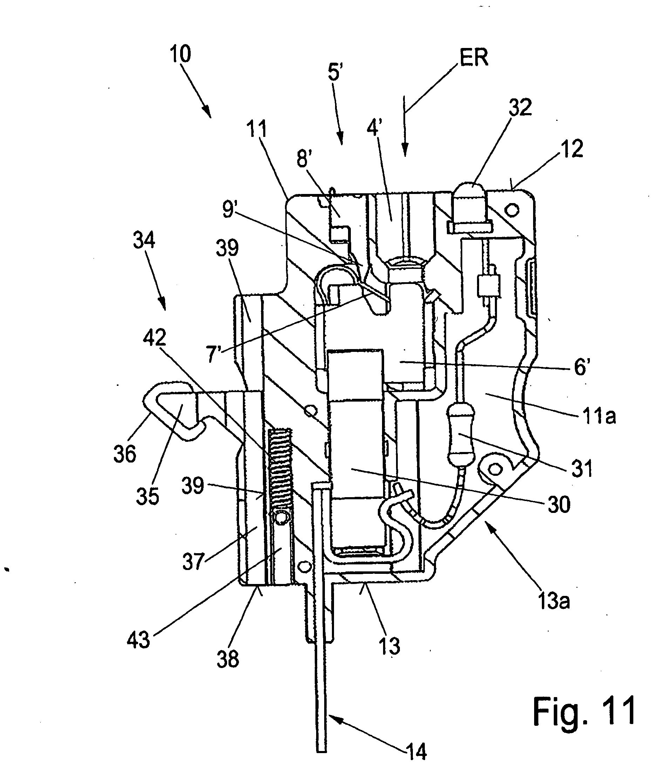

Schließlich zeigt Figur 11 den Zusatzanschlussstecker 10 nach Figur 10 in bestückter Version mit senkrecht angeordnetem Sicherungselement 30. In dieser nicht eingesteckten Position des Zusatzanschlusssteckers 10 fluchtet der Druckabschnitt 38 des Schiebeelementes 37 mit der Unterseite 13 des Gehäuses 11.

Die Erfindung ist nicht auf die oben erläuterten Ausführungsbeispiele schränken die Erfindung nicht ein; sie ist im Rahmen der beigefügten Ansprüche modifizierbar.

Das Stromschienenelement 15 kann vorzugsweise aus einem elektrisch leitenden Werkstoff, wie zum Beispiel Kupfer oder Aluminium oder einer Legierung mit einem dieser Werkstoffe, bestehen.

Es ist auch denkbar, dass der Querschnitt des Schiebeelementes 37 kreisförmig ist, wobei kein Griff 35 vorhanden ist und das obere Ende des Schiebeelementes 37 durch einen Drücker oder ein Werkzeug betätigbar ist.

Weiterhin ist denkbar, dass das Schiebeelement 37 mehrteilig ist.

### Bezugszeichen

- 1: Anschlussvorrichtung
- 2: Anschlussklemme
- 3: Stirnseite
- 4, 4': Einführungsöffnung
- 5, 5': Betätigungseinrichtung
- 6, 6': Anschlusseinrichtung
- 6a: Käfig
- 6b: Kontaktstück
- 6c: Kontaktfläche
- 6d: Vorsprung
- 6e: Federhalter
- 7,7': Klemmfeder
- 7a: Kante
- 7b: Bogenabschnitt
- 7c: Halteschenkel
- 8, 8': Betätiger
- 9, 9': Betätigungsabschnitt
- 10: Zusatzanschlussstecker
- 11: Gehäuse
- 12: Oberseite
- 13: Unterseite
- 13a: Schräge
- 14: Stromschieneneinrichtung
- 15: Kern/Stromschienenabschnitt/-element
- 16: Träger
- 17: Klemmabschnitt
- 17a: Klemmfläche
- 18: Randabschnitt
- 19: Steckerkontaktfläche
- 20: Verriegelungselement
- 21: Gelenk
- 22: Druckabschnitt
- 23: Haken
- 24: Rastabschnitt
- 25: Direktsteckanschluss
- 26: Klemmbereich
- 27: Kontaktbereich
- 28: Schildschiene
- 29: Profil
- 30: Sicherungselement
- 31: Widerstand
- 32: Anzeigeelement
- 33: Leiter
- 34: Löseeinrichtung
- 35: Griff
- 36: Verbindungselement
- 37: Schiebeelement
- 38: Druckabschnitt
- 39: Führungskanal
- 40: Verbindungsstift
- 41, 41': Langlochführung
- 42: Feder
- 43: Stift
- ER: Einführungsrichtung

## Patentansprüche

1. Zusatzanschlussstecker (10) für elektrische Leiter, zum Einstecken in Direktsteckanschlüsse (25) mit Klemmfeder (7) von Anschlusseinrichtungen (6) von Anschlussklemmen (2), mit
- einem Gehäuse (11) mit einer Anschlusseinrichtung (6') und einer Einführungsöffnung (4') zur Einführung eines elektrischen Leiters in die Anschlusseinrichtung (6') des Zusatzanschlusssteckers (10);
- eine Stromschieneneinrichtung (14), welche in dem Gehäuse (11) festgelegt ist und sich außerhalb des Gehäuses (11) in einer bestimmten Länge von einer Unterseite (13) des Gehäuses (11) ausgehend erstreckt;
**dadurch gekennzeichnet, dass**
- die Stromschieneneinrichtung (14) einen Klemmabschnitt (17) aufweist, welcher eine derartige Oberflächenbeschaffenheit aufweist, dass er im in den Direktsteckanschluss eingesteckten Zustand in diesem nicht selbsthemmend gehalten ist, d.h. einsteckt,
- wobei die Stromschieneneinrichtung (14) mehrteilig aus mindestens zwei Schichten aufgebaut ist,
- wobei der Klemmabschnitt (17) mit einem harten Metall, nämlich Stahl, beschichtet ist.

2. Zusatzanschlussstecker (10) nach Anspruch 1, **dadurch gekennzeichnet, dass** das Stromschieneneinrichtung (14) einen Kern (15) als elektrisch leitenden Stromschienenabschnitt aufweist, der abschnittsweise mit Kunststoff ummantelt ist.

3. Zusatzanschlussstecker (10) nach Anspruch 1 oder 2, **dadurch gekennzeichnet, dass** der Zusatzanschlussstecker (10) mit einem Verriegelungselement (20) zur Verriegelung mit der zuzuordnenden Anschlussklemme (2) versehen ist.

4. Zusatzanschlussstecker (10) nach Anspruch 3, **dadurch gekennzeichnet, dass** das Verriegelungselement (20) an dem Gehäuse (11) des Zusatzanschlusssteckers (10) wieder entfernbar anbringbar ist.

5. Zusatzanschlussstecker (10) nach einem der vorstehenden Ansprüche, **dadurch gekennzeichnet, dass** die Anschlussvorrichtung (6')mit einer Betätigungseinrichtung (5') zum Lösen der Anschlusseinrichtung (6') des Zusatzanschlusssteckers (10) aus einer Klemmstellung versehen ist

6. Zusatzanschlussstecker (10) nach einem der vorstehenden Ansprüche, **dadurch gekennzeichnet, dass** die Anschlusseinrichtung (6') als Direktsteckanschluss mit einer Klemmfeder (7') mit Selbsthemmung ausgebildet ist.

7. Zusatzanschlussstecker (10) nach einem der vorhergehenden Ansprüche, **dadurch gekennzeichnet, dass** die Betätigungseinrichtung (5') und die Einführungsöffnung (4') für den elektrischen Leiter auf einer Oberseite (12) des Gehäuses (11) des Zusatzanschlusssteckers (10) angeordnet sind, wobei die Betätigungseinrichtung (5') in einer Einführungsrichtung (ER) betätigbar ist.

8. Zusatzanschlussstecker (10) nach einem der vorhergehenden Ansprüche, **dadurch gekennzeichnet, dass** die Betätigungseinrichtung (5') einen Betätiger (8') aufweist, der in einer Einführrichtung (ER) von der Oberseite (12) her betätigbar und verschiebbar im Gehäuse (11) geführt ist.

9. Zusatzanschlussstecker (10) nach einem der vorhergehenden Ansprüche, **dadurch gekennzeichnet, dass** das Gehäuse (11) zur Bestückung mit Sicherungselementen (30) und/oder Anzeigeelementen (32) sowie weiteren Bauteilen vorgesehen ist.

10. Anschlussvorrichtung (1) mit mindestens einer Anschlussklemme (2) mit einer Anschlusseinrichtung (6), welche als Direktanschluss (25) mit einer Klemmfeder (7) ausgebildet ist, und mit wenigstens mindestens einem Zusatzanschlussstecker (10) nach einem der vorhergehenden Ansprüche.

## Claims

1. An additional connection plug (10) for electrical conductors, for plugging into direct plug connections (25) with clamping spring (7) of connection devices (6) of connection terminals (2), comprising
- a housing (11) with a connection device (6') and an insertion opening (4') for inserting an electrical conductor into the connection device (6') of the additional connection plug (10);
- a busbar device (14) which is fixed in the housing (11) and extends outside of the housing (11) over a certain length, starting from a bottom side (13) of the housing (11);
**characterized in that**
- the busbar device (14) comprises a clamping section (17) which has such a surface configuration that in the state where it is inserted into the direct plug connection it is retained therein in a non-self-locking manner, i.e. inserted,
- wherein the busbar device (14) is composed from several parts from at least two layers, and
- wherein the clamping section (17) is coated with a hard metal, namely steel.

2. An additional connection plug (10) according to claim 1, **characterized in that** the busbar device (14) has a core (15) as an electrically conductive bus bar section which is sheathed in sections with plastic.

3. An additional connection plug (10) according to claim 1 or 2, **characterized in that** the additional connection plug (10) is provided with a locking element (20) for locking with the connection terminal (2) to be assigned.

4. An additional connection plug (10) according to claim 3, **characterized in that** the locking element (20) can releasably be attached to the housing (11) of the additional connection plug (10).

5. An additional connection plug (10) according to one of the preceding claims, **characterized in that** the connection apparatus (6') is provided with an actuation device (5') for releasing the connection device (6') of the additional connection plug (10) from a clamped position.

6. An additional connection plug (10) according to claim 6, **characterized in that** the connection device (6') is formed as a direct plug connection with a clamping spring (7') with a self-locking configuration.

7. An additional connection plug (10) according to one of the preceding claims, **characterized in that** the actuation device (5') and the insertion opening (4') for the electrical conductor are arranged on an upper side (12) of the housing (11) of the additional connection plug (10), wherein the actuation device (5') can be actuated in an insertion direction (ER).

8. An additional connection plug (10) according to one of the preceding claims, **characterized in that** the actuation device (5') comprises an actuator (8') which can be actuated in an insertion direction (ER) from the upper side (12) and is displaceably guided in the housing (11).

9. An additional connection plug (10) according to one of the preceding claims, **characterized in that** the housing (11) is provided for assembly with securing elements (30) and/or display elements (32) and further components.

10. A connection apparatus (1), comprising at least one connection terminal (2) with a connection device (6), which is formed as a direct connection (25) with a clamping spring (7), and comprising at least one additional connection plug (10) according to one of the preceding claims.

## Revendications

1. Fiche de connexion supplémentaire (10) pour conducteurs électriques, à insérer dans des raccords à enfichage direct (25) à ressorts de serrage (7) de dispositifs de connexion (6) de bornes de connexion (2), avec
- un boîtier (11) avec un dispositif de connexion (6') et une ouverture d'insertion (4') pour l'insertion d'un conducteur électrique dans le dispositif de connexion (6') de la fiche de connexion supplémentaire (10) ;
- un dispositif de barre collectrice (14) fixé dans le boîtier (11) et qui s'étend à l'extérieur du boîtier (11) sur une certaine longueur à partir d'une face inférieure (13) du boîtier (11) ;
**caractérisée en ce que**
- le dispositif de barre collectrice (14) comporte une section de serrage (17) dont la texture de surface est telle qu'elle n'est pas retenue, c'est-à-dire insérée, de manière autobloquante dans la prise de connexion directe dans l'état inséré dans celle-ci,
- le dispositif de barre collectrice (14) étant composé en plusieurs parties avec au moins deux couches, et
- la section de borne (17) étant revêtue d'un métal dur, à savoir d'acier.

2. Fiche de connexion supplémentaire (10) selon la revendication 1, **caractérisée en ce que** le dispositif de barre collectrice (14) comporte une âme (15) faite d'une section conductrice électrique de barre conductrice, qui est revêtue par sections de matière plastique.

3. Fiche de connexion supplémentaire (10) selon la revendication 1ou 2, **caractérisée en ce que** la fiche de connexion supplémentaire (10) est munie d'un élément de verrouillage (20) pour le verrouillage de la borne de connexion (2) associée.

4. Fiche de connexion supplémentaire (10) selon la revendication 3, **caractérisée en ce que** l'élément de verrouillage (20) peut être posé sur le boîtier (11) de la fiche de connexion supplémentaire (10) de façon à pouvoir en être enlevé.

5. Fiche de connexion supplémentaire (10) selon l'une des revendications précédentes, **caractérisée en ce que** le dispositif de connexion (6') est muni d'un mécanisme d'actionnement (5') destiné à détacher le dispositif de connexion (6') de la prise de connexion supplémentaire (10) à partir d'une position de serrage.

6. Fiche de connexion supplémentaire (10) selon la revendication 6, **caractérisée en ce que** le dispositif de connexion (6') est conçu comme une connexion directe avec un ressort de serrage (7') autobloquant.

7. Fiche de connexion supplémentaire (10) selon l'une des revendications précédentes, **caractérisée en ce que** le mécanisme d'actionnement (5') et l'ouverture d'insertion (4') pour les conducteurs électriques sont disposés sur une face supérieure (12) du boîtier (11) de la fiche de connexion supplémentaire (10), le mécanisme d'actionnement (5') pouvant être actionné dans un sens d'introduction (ER).

8. Fiche de connexion supplémentaire (10) selon l'une des revendications précédentes, **caractérisée en ce que** le mécanisme d'actionnement (5') comporte un actionneur (8') qui peut être actionné dans un sens d'introduction (ER) depuis la face supérieure (12) et qui est guidé de façon coulissante dans le boîtier (11).

9. Fiche de connexion supplémentaire (10) selon l'une des revendications précédentes, **caractérisée en ce que** le boîtier (11) est conçu pour être équipé d'éléments de sécurité (30) et/ou d'éléments indicateur (32) ainsi que d'autres composants.

10. Dispositif de connexion (1) avec au moins une borne de connexion (2) munie d'un dispositif de connexion (6) qui est conformé comme une connexion directe (25) avec un ressort de serrage (7) et avec au moins une fiche de connexion supplémentaire (10) selon l'une des revendications précédentes.
